Europäisches Patentamt

European Patent Office

Office européen des brevets

(11) Veröffentlichungsnummer: **0 143 111**
**A1**

(19)

# (12) EUROPÄISCHE PATENTANMELDUNG

(21) Anmeldenummer: 83111837.7

(22) Anmeldetag: 25.11.83

(51) Int. Cl.⁴: **G 01 R 19/165**

(43) Veröffentlichungstag der Anmeldung: 05.06.85
Patentblatt 85/23

(84) Benannte Vertragsstaaten: **AT BE CH DE FR IT LI NL**

(71) Anmelder: **Tüzeléstechnikai Kutato- és Fejlesztö Vailalat, H-3515 Miskolc-Egyetemváros (HU)**

(72) Erfinder: **Asztalos, Gábor, Dipl.-El., Középszer u. 96, H-3529 Miskolc (HU)**
Erfinder: **Kuthi, István, Dipl.-El., Kuruc u. 55, H-3535 Miskolc (HU)**
Erfinder: **Horvath, Szabolcs, Dipl.-El., Homezö u. 32, H-1221 Budapest (HU)**
Erfinder: **Riba, Dezsö, Dr. Dipl.-Ing., Pozsonyi u. 39, H-3526 Miskolc (HU)**

(74) Vertreter: **Patentanwälte Viering & Jentschura, Steinsdorfstrasse 6, D-8000 München 22 (DE)**

(54) Schaltungsanordnung eines Fensterkomparators mit Selbstkontrolle.

(57) Schaltungsanordnung eines Fensterkomparators mit Selbstkontrolle. Bei der Schaltungsanordnung sind ein Pol der Eingangsspannung ($U_E$) an den einen Eingang eines Komparators (K), und ein anderer Pol an einen Punkt einer Spannungsquelle (U) geschaltet, der ein Teilerverhältnis von U/W aufweist. Der andere Eingang des Komparators (K) ist an eine gesteuerte Spannungsquelle (G) angeschlossen und der Ausgang des Komparators (K) ist über ein Verzöge-rungselement (I) an ein Steuerelement (V) geführt, wobei der Ausgang des Komparators (K) und/oder des Steuerelementes (V) über einen auf die Betriebsfrequenz abgestimmten Filter (SZ) an einen Signalwandler (Ja) angeschlossen ist. Dadurch ist die innere Funktion des Fensterkomparators dynamisch und dieser führt während seiner Funktion eine Selbstkontrolle durch, d.h. er erzeugt bei innerer Unterbre-chung bzw. bei Kurzschluß an seinem Ausgang kein fal-sches Signal und ist so zur Anwendung in Vorrichtungen zur Schaltung von sicherheitstechnischen Grenzwerten geeig-net.

## Schaltungsanordnung eines Fensterkomparators
## mit Selbstkontrolle

Durch die Erfindung ist eine Schaltungsanordnung eines mit einer Signalverarbeitungseinheit versehenen Fensterkomparators geschaffen, der zwischen einem unteren und einem oberen Wert eines Eingangssignals ein Ausgangssignal erzeugt und dessen innere Funktion während der Signalausgabe dynamisch ist und der während seiner Funktion eine Selbstkontrolle durchführt, d.h. bei innerer Unterbrechung bzw. bei Kurzschluß an seinem Ausgang kein falsches Signal erzeugt und so zur Anwendung in Vorrichtungen zur Schaltung von sicherheitstechnischen Grenzwerten geeignet ist.

Aus der Fachliteratur und der Praxis sind solche Schaltungsanordnungen und Lösungen bekannt, mittels denen festgestellt werden kann, ob irgendein Wert eines Parameters in einem vorgegebenen Bereich oder außerhalb dieses Bereiches liegt. Auf Grund des erhaltenen Signals können Maßnahmen getroffen werden.

Die Grundschaltung von Spannungskomparatoren und Fensterkomparatoren sind aus der Literatur (U. Tietze-CH. Schenk "Analoge und digitale Schaltungen", Technischer Buchverlag, Budapest 1974, 2. Ausgabe, Seite 294, und Herpy "Analoge integrierte Schaltungen", Technischer Buchverlag, 1974, 2. Ausgabe, Abschnitt 611) bekannt.

Anwendungsgebiete von Fensterkomparatoren sind Grenzwertmelder und Ausgangsstufen von verschiedenen Schaltgeräten,
wie z.B. die im Handel unter der Bezeichnung "Witronic"
oder "ASM" erhältlichen, bekannten Reglergeräte mit drei
Schaltstellungen.

Ein gemeinsames Merkmal der obigen Schaltungen besteht darin, daß zum Vergleichen des oberen und unteren Grenzwertes
je ein gesonderter Komparator verwendet wird und die Schaltung nicht mit Selbstkontrolle funktioniert. Aus der HU-PS
161 501 sind ein Verfahren und eine Vorrichtung bekannt,
für die nur ein Amplitudenkomparator vorgesehen ist und
die zur Einkanal-Amplitudenanalyse von mit kernphysikalischen Detektoren erzeugten elektrischen Rechteckimpulsen
geeignet ist.

Das aus der obigen Patentschrift bekannte Verfahren ermöglicht im Falle von Rechteckimpulsen die Prüfung von deren
Amplitude und die Beseitigung der erwähnten Mängel dadurch,
daß nur eine einzige Komparatorschaltung verwendet wird,
die die Amplitude des Impulses zeitlich nacheinander zuerst mit dem Diskriminationspegel und danach mit dem um
eine Fensterbreite größeren Spannungspegel vergleicht. Das
zeitlich bestimmte Nacheinander der am Ausgang des Komparators erscheinenden logischen Pegel gibt eine Information
über die Größe des Impulses, der mittels Logiktorschaltungen separiert wird. Die gleiche Logikschaltung sorgt für
die automatische Steigerung des Diskriminationspegels, wenn
der zu messende Impuls größer als der eingestellte Diskriminationspegel ist. Ein Nachteil der Vorrichtung besteht
darin, daß diese ohne Selbstkontrolle arbeitet und somit
den sicherheitstechnischen Anforderungen nicht genügt und
für Gleichstromsignale nicht verwendbar ist.

Hinsichtlich der Lebens- und Vermögenssicherheit treten strengere sicherheitstechnische Anforderungen auf wichtigen und gefährlichen Gebieten immer mehr in den Vordergrund. Diese Anforderungen können in einigen Fällen durch eine Vervielfältigung der einfachen Lösungen oder durch die Anwendung von mehreren "Kanälen" erfüllt werden.

Solche sind z.B. die im Handel erhältlichen TR16/TRS - und TR 112/TRS - Temperaturschalter, die Zweikanalsysteme darstellen.

Mittels gesonderter, auf einen unteren und oberen Grenzwert eingestellter Komparatoren wird ein "Fenster" gebildet und diese Lösung wird verzweifacht. Die Ausgänge der Kanäle sind statische, die über Transistorverstärker Relais betätigen.

Nachteil dieser Vorrichtung ist, daß sie infolge der Anwendung von zwei Kanälen aufwendig ist, und durch die Erhöhung der Anzahl der Kanäle die Wahrscheinlichkeit der unzulässigen Fehler nur verringert wird.

Ziel der Erfindung ist es, die erwähnten Mängel zu beseitigen und eine Schaltungsanordnung eines Fensterkomparators zu schaffen, die den strengeren sicherheitstechnischen Anforderungen genügt, d.h. bei innerer Unterbrechung oder Kurzschluß am Ausgang kein falsches Signal erzeugt, eine einkanalige Lösung darstellt sowie sowohl durch Gleichspannungs- als auch Wechselspannungssignale betätigt werden kann.

Erfindungsgemäß ist zur Erfüllung der gesteigerten sicherheitstechnischen Anforderungen ein dynamisch funktionierender frequenzkontrollierter Fensterkomparator geschaffen.

Die Erfindung zeigt auf, wie Fensterkomparatoren so aufgebaut sein können, daß sie den strengen Sicherheitsanforderungen genügen.

Die Schaltungsanordnungen des erfindungsgemäß selbstkontrollierten Fensterkomparators werden anhand der Zeichnung erläutert. In der Zeichnung zeigt:

Fig. 1 die allgemeine Form der Schaltanordnung

Fig. 2 die Schaltanordnung einer als Beispiel dinenden Ausführungsform.

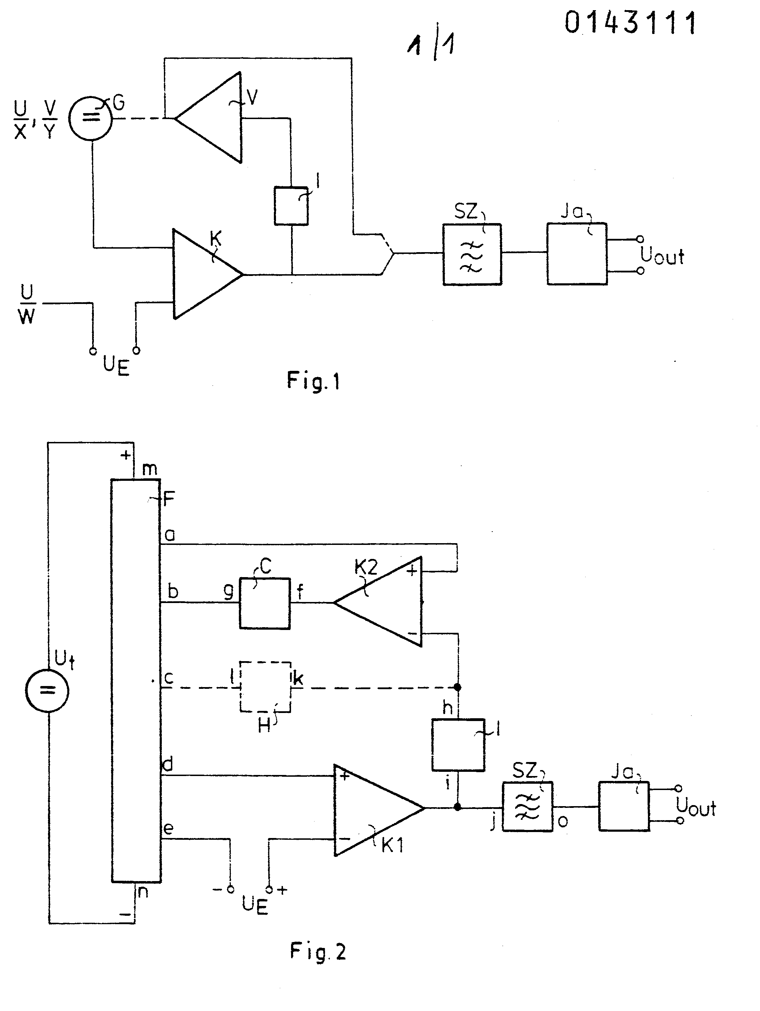

Bei der Schaltanordnung des selbstkontrollierten Fensterkomparators gem. Fig. 1 sind der eine Pol der Eingangsspannung $U_{be}=U_E$ auf den einen Eingang des Komparators K, und der andere Pol auf ein durch ein U/W-Teilerverhältnis gekennzeichnetes Potential einer Spannungsquelle U geschaltet; der andere Eingang des Komparators K ist an eine gesteuerte Spannungsquelle G angeschlossen. Die gesteuerte Spannungsuelle stellt zwei durch ein U/X-, bzw U/Y- Teilerverhältnis gekennzeichnete Spannungszustände her. Der Ausgang des Komparators K wirkt über das Verzögerungselement I auf das Steuerungselement V, von welchem die Spannungsquelle G gesteuert ist. Der Ausgang des Komparators K und/oder der Ausgang des Steuerungselementes V ist über einen auf die Betriebsfrequenz SZ abgestimmten Filter an einen Signalwandler Ja geschaltet.

Für den Betrieb müssen die Potentiale mit den Werten von U/X, U/Y und U/W so vorbestimmt und die Eingangsspannung $U_{be}$ mit einer solchen Polarität angeschlossen werden, daß der gewünschte Funktionsbereich zwischen die durch die U/X- und U/Y-Teilerverhältnisse gekennzeichneten Spannungswerte fällt. Weiterhin soll sich bei dem Vergleich mit den Spannungswerten U/X bzw. U/Y - jedoch nur, sofern sich die Spannung $U_{be}$ im Funktionsbereich befindet - bei dem Vergleich mit dem niedrigeren Wert derjenige Zustand einstellen, bei dem der Komparator K auf das Steuerungselement V so wirkt, daß das Steuerungselement die gesteuerte Spannungsquelle G auf die größere Spannung umschaltet. Bei dem Vergleich mit dem höheren Wert soll sich der andere Zustand des Ausganges des Komparators K einstellen, so daß der Komparator auf das Steuerungselement V so wirkt, daß es die gesteuerte Spannungsquelle G auf die kleinere Spannung umschaltet.

An dem Ausgang des Komparators K und des Steuerungselementes V erscheint in dieser Weise eine Impulsfolge, die über das auf diese Frequenz abgestimmte Filter auf den Eingang des Signalumwandlers Ja gelangt.

Der Signalumwandler Ja ist an sich bekannt und verfügt vorzugsweise über eine Impulsverstärkerstufe und ein eine galvanische Abtrennung sicherndes Element und vorzugsweise über eine Gleichrichterschaltung, und in diesem Fall hängt die JA-NEIN Ausgangsinformation von der An- oder Abwesenheit der Gleichspannung ab.

Eine vorteilhafte Ausführungsform der Schaltanordnung ist aus Fig. 2 ersichtlich, wo die Verwirklichung des gesteuerten Spannungsgenerators und des U/W Potentials durch eine Widerstandschaltung geschieht, auf das Steuerungselement direkt wirkt. Das Steuerungselement ist vorzugsweise auch ein Komparatorstromkreis, bei dem vorzugsweise seine eigene Hysterese verwirklicht ist. Das Verzögerungselement ist vorzugsweise ein Integrationsglied.

Der an die Speisespannungsquelle $U_t$ geschaltete, gegebenenfalls aus einer Reihenschaltung von Widerständen und eine Zenerdiode zusammengestellte Spannungsteiler F verfügt vorzugsweise über fünf Anschlüsse, nämlich über den Impulsbetriebsfaktor bestimmenden Spannungsausgang a, den auf die Größe des Fensters wirkenden Spannungseingang b, den eine Hysterese erzeugenden Spannungseingang c, den die Vergleichsspannung bestimmenden Spannungsausgang d und über den das U/W-Potential bestimmenden Spannungsausgang e. An den den Impulsbetriebsfaktor bestimmenden Spannungsausgang a ist der nichtinvertierende Eingang (+) des Komparators K2 geschaltet und der Ausgang des Komparators K2 ist an den Eingang f des Kopplungsgliedes C geschaltet.

Das Kopplungsglied C kann ein Widerstand, ein Potentiometer oder eine Diode sein bzw. eine Reihenschaltung, deren Variationen von der Anwendungsart abhängt. Der Ausgang c des Kopplungsgliedes C ist an den Eingang b des Spannungsteilers F geschaltet. Der invertierende Eingang (-) des Komparators K2 ist an den Ausgang h des Integrationsgliedes I, und - bei einer vorteilhaften Ausführungsform - an den Eingang k des die Hysterese erzeugenden Gliedes H geschaltet. Das die Hysterese hervorrufende Glied H ist eine Diode, eine Zenerdiode, ein Widerstand, ein Zweipol aus einer Schaltung von Bauelementen, dessen Ausgang l an den die Hysterese c erzeugenden Spannungseingang des Spannungsteilers F geführt ist. An den Eingang i des Integrationsgliedes I sind der Ausgang des Komparators K1, und der Eingang des Filters SZ geschaltet. Der nichtinvertierende Eingang (+) des zweiten Komparators K1 ist an den die Vergleichsspannung bestimmenden Spannungsausgang d des Spannungsteilers F angeschlossen. Der invertierende Eingang (-) des Komparators K1 und der Spannungsausgang e des Spannungsteilers F sind an die zu kontrollierende Spannungsquelle $U_{be}$ angeschlossen. Der erste und zweite Komparator K1 und K2 sind vorzugsweise Operationsverstärker, das Integrationsglied I ist vorzugsweise ein aus R- und C-Gliedern zusammengestellter Vierpol. Die Endpunkte m und n des Spannungsteilers F sind an die Speisespannungsquelle geschaltet.

Einige Ausgänge des Spannungsteilers F können vereinigt werden. Der den Impulsbetriebsfaktor bestimmende Spannungsausgang, der auf die Größe des Spannungsfensters einwirkende Spannungseingang und der die Hysterese erzeugende Spannungseingang c können in jeder Variation vereinigt werden – abhängig von der Größe des gewünschten Spannungsfensters, dem Impulsbetriebsfaktor bzw. der Hysterese.

Die Reihenfolge dieser Ausgänge hängt von den gezählten Spannungswerten ab. Die Spannungsausgänge d und e dürfen nicht unmittelbar miteinander verbunden sein und zwischen ihnen befindet sich mindestens ein Widerstand.

Die Funktion des Schaltkreises stimmt mit der des vorher beschriebenen überein. Die jeweilige Vergleichsspannung d.h. deren unterer bzw. oberer Grenzwert, ist von der jeweiliger Betriebsphase abhängig. Der Ausgang des den Vergleich durchführenden Komparators K1 nimmt bei dem Vergleich mit dem unteren Grenzwert den einen, und beim Vergleich mit dem oberen Grenzwert den anderen Zustand an. Mit diesem Signal wird der Komparator K2 über das Integrationsglied I gesteuert, der mit seinem Ausgang auf das Spannungsteilernetz wirkt und dadurch wird der andere Grenzwert eingestellt.

Die Vergleichsergebnisse verursachen nur dann ein Umschalten, wenn sich die geprüfte Spannung innerhalb des Funktionsbetriebes befindet. Die obige Prüfreihe bedeutet eine Impulserzeugung gegebener Frequenz am Ausgang der Komparatoren. Falls sich die geprüfte Spannung außerhalb einer der Grenzen des Bereichs befindet oder diese überschreitet oder sich auf der vorbestimmten Grenze aufhält, endet die Impulserzeugung. Bei einer vorteilhaften Ausführungsform gibt das die Hysterese erzeugende H-Glied der Schaltung einen Hysteresecharakter.

Die Betriebsfrequenz ist von den Widerstandsverhältnissen am Komparator K2 und der Zeitkonstanten des Integrationsgliedes I bestimmt; die Schaltgrenzen sind durch die Auslegung des Spannungsteilers F und des Kopplungsgliedes C
gegeben. Der auf die Betriebsfrequenz abgestimmte Bereichsfilter gibt die ihn durchlangenden Impulse vorzugsweise
mit Hilfe des Ja-Signalumwandlers und eines Ausgangstransformators an den Ausgang. An dem Ausgang erscheint vorzugsweise eine Gleichrichterspannung. Die Funktion ist dynamisch; der Schaltkreis befriedigt die sicherheitstechnischen Anforderungen.

Wegen der Selbstkontrolle kann die Erfindung bei Anwendung
solcher Einrichtungen vorteilhaft angewendet werden, die
den strengeren Anforderungen an die Lebens- und Vermögenssicherung genügen müssen, zum Beispiel bei Grenzwertschalteinrichtungen, Sicherheitsschaltkreisen, zur Verwirklichung
verschiedener in der Feuerungstechnik verwendbarer Sperrgeber und in Schaltkreisen für die Bahnsicherheit.

0143111

Patentansprüche

1. Schaltungsanordnung eines Fensterkomparators mit Selbstkontrolle, dadurch gekennzeichnet, daß ein Pol der Eingangsspannung ($U_E$) an einen Eingang eines Komparators (K), ein anderer Pol an einen Punkt einer Spannungsquelle (U) geschaltet ist, der ein Teilerverhältnis von U/W aufweist, ein anderer Eingang des Komparators (K) an eine gesteuerte Spannungsquelle (G) angeschlossen ist, ein Ausgang des Komparators (K) über ein Verzögerungselement (I) an ein Steuerelement (V) geführt ist und ein Ausgang des Komparators (K) und/oder des Steuerelementes (V) über einen auf die Betriebsfrequenz abgestimmten Filter (SZ) an einen Signalwandler (Ja) angeschlossen ist.

2. Schaltungsanordnung nach Anspruch 1, dadurch gekennzeichnet, daß ein den Impulsbetriebsfaktor bestimmender Spannungsausgang (a) eines Spannungsteilers (F) an einen nichtinvertierenden Eingang eines ersten Komparators (K2) angeschlossen ist, der invertierende Eingang des ersten Komparators (K2) an einen Ausgang (h) eines Integrationsgliedes (I) angeschlossen ist, der Ausgang des ersten Komparators (K2) an einen Eingang (f) eines Kopplungsgliedes (C) angeschlossen ist, und ein Ausgang (g) des Kopplungsgliedes (C) an einen auf die Größe des Spannungsfensters einwirkenden Eingang (b) des Spannungsteilers (F) angeschlossen ist, daß ein Eingang (i) des Integrationsgliedes (I) an den Ausgang eines zweiten Komparators (K1) und einen Eingang (j) des Filters (SZ) geführt ist, der nichtinvertierende Eingang des zweiten Komparators (K1) an einen die Vergleichsspannung bestimmenden Spannungsausgang (d) des Spannungsteilers (F) geführt ist, der invertierende Eingang des Komparators (K1) sowie ein das Potential (U/W) des Spannungsteilers (F) bestimmender Spannungsausgang (e) mit der zu prüfenden Spannungsquelle ($U_{be}$) verbunden sind und zwei Endpunkte (m,n) des Spannungsteilers (F) mit einer Speisespannungsquelle ($U_t$) verbunden sind, und daß an einen Ausgang (o) des Filters (SZ) eine Signalverarbeitungseinheit (Ja) angeschlosen ist.

3. Schaltungsanordnung nach Anspruch 1 oder 2, dadurch gekennzeichnet, daß der invertierende Eingang des ersten Komparators (K2) sowie der Ausgang (h) des Integrationsgliedes (I) an einen Eingang (k) eines Hysterese erzeugenden Gliedes (H) geführt sind, dessen Ausgang (1) an einen eine Hysterese erzeugenden Spannungseingang (c) des Spannungsteilers (F) geführt ist.

Fig.1

Fig.2

0143111

1|1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| X | GB-A-2 028 041 (MESSERSCHMITT-BÖLKOW-BLOHM GmbH) * Figur 3; Seite 2, linke Spalte, Zeilen 6-19; Seite 3, Zeilen 31-120; Seite 4, Anspruch 5; Seite 5, Ansprüche 8-10 * | 1 | G 01 R 19/165 |
| A | | 3 | |
| | --- | | |
| A | DE-A-2 262 208 (STANDARD ELEKTRIK LORENZ AG) | | |
| | --- | | |
| A | DE-A-3 121 841 (HONEYWELL S.A.) | | |
| | ----- | | |

**RECHERCHIERTE SACHGEBIETE (Int. Cl. 3)**

G 01 R
H 03 K

Der vorliegende Recherchenbericht wurde für alle Patentansprüche erstellt.

| Recherchenort DEN HAAG | Abschlußdatum der Recherche 27-07-1984 | Prüfer KAUFFMANN J. |
|---|---|---|